# EUROPEAN PATENT SPECIFICATION

(11) **EP 0 609 916 B1**
(45) Date of publication and mention of the grant of the patent: **20.06.2001**
(21) Application number: 94106184.8
(22) Date of filing: 13.08.1990
(51) Int. Cl.: H03M 1/12

(54) **Superconducting analog-to-digital converter and techniques for its reading**
Supraleitender Analog-Digitalwandler und Leseverfahren dafür
Convertisseur analogique-numérique et procédé de lecture dudit convertisseur

(30) Priority: 24.08.1989 US 397923
(43) Date of publication of application: 10.08.1994
(62) Divisional of application: 90308873.0
(73) Proprietor: TRW INC., Cleveland Ohio 44124 (US)
(72) Inventor: Lee, Gregory S., West Los Angeles, CA 90025 (US)
(74) Representative: Crawford, Andrew Birkby

(56) References cited:
- EP-A- 0 174 105
- PATENT ABSTRACTS OF JAPAN vol. 013, no. 123 (E-733) 27 March 1989 & JP-A-63 292 721 (MATSUSHITA ELECTRIC) 30 November 1988
- PROCEEDINGS OF THE IEEE, vol.77, no.8, August 1989, NEW YORK pages 1264 - 1273, XP000071600 LEE ET AL 'superconductive A/D Converters'

## Description

This invention relates generally to analog-to-digital converters and, more particularly, to techniques for facilitating the reading of bidirectional counters used in high speed, high-resolution analog-to-digital converters employing superconducting Josephson junctions.

High-performance analog-to-digital (AID) converters are required in a variety of commercial and military electronic devices. Two of the more important measures of an A/D converter's performance are its speed, as measured by the number of samples converted per second, and resolution, as measured by the smallest increment of change that can be detected in an analog signal. Superconducting technology is particularly well suited to performing high-speed, high-resolution A/D conversion because Josephson junctions, which are the basic switching elements utilized in superconducting electronic devices, possess a unique combination of speed, sensitivity, and periodic response characteristics.

The Josephson junction is a simple bistable switching device having a very thin insulating layer sandwiched between two superconducting electrodes. When current supplied to the Josephson junction is increased above the critical current of the junction, the device is switched from a superconducting zero-voltage state to a resistive voltage state. The resistive voltage state, in which the voltage drop across the device is equal to the energy gap of the superconductor material, is switched off by reducing the current supplied to the junction to about zero. Because this switching operation can occur in as little as a few picoseconds, the Josephson junction is truly a high speed switching device. In a superconducting A/D converter, one or more of the Josephson junctions are combined with one or more inductive loads to form a logic circuit called a SQUID, or Superconducting Quantum Interference Device.

The characteristics of the SQUID that provide the basis for superconducting A/D conversion can best be explained with reference to a single-junction SQUID.The single-junction SQUID, which is simply a Josephson junction connected across an inductance to form a superconducting loop, exhibits a periodic and multivalued relationship between the current injected into the inductance and the magnetic flux in the loop. The magnetic flux in the loop increases by a small quantum whenever the current increases by a small and precisely repeatable increment. This quantum of flux gives rise to a small but measurable voltage pulse across the junction. When the current is decreased by a like increment, the magnetic flux in the loop decreases by the small quantum, and a corresponding voltage pulse of the opposite polarity is produced across the junction.

In order to convert a signal from analog to digital form using the single-junction SQUID, the analog signal is introduced into the SQUID as a varying current. Each time the current increases or decreases by a predetermined amount, a measurable voltage pulse is generated across the junction. In this manner, the SQUID functions as a quantizer, with the resultant pulses being detected and counted in one or more binary counters. The principle advantages of this superconducting counting A/D converter are its near perfect linearity and its high sensitivity and speed. The current increment or decrement, which determines the resolution of the device, can be made extremely small. This is because a single flux quantum is only 2.07 x 10⁻¹⁵ weber and the current increment or decrement is the flux quantum divided by the value of the inductance (measured in henries).

U.S. Patent No. 4,646,060 to Phillips et al. discloses a superconducting counting A/D converter having a double-junction SQUID quantizer and a bidirectional binary counter comprised of n stages of double-junction SQUID flip-flops, where n is the number of bits of accuracy of the counter. The quantizer generates up-count and down-count voltage pulses of the same polarity on two different output lines, rather than voltage pulses of the opposite polarity on the same output line, as in the single-junction SQUID. The bidirectional binary counter algebraically counts the voltage pulses, increasing the binary count when up-count pulses are received and decreasing the binary count when down-count pulses are received. Superconducting logic circuitry, which includes numerous AND and OR gates, provides the carry and borrow functions of the counter.

Although the Phillips et al. A/D converter has certain advantages, it also has several disadvantages. One disadvantage is that the additional logic circuitry reduces the speed and increases the device count of the A/D converter. An increased device count reduces the reliability of the A/D converter and also increases its cost. Accordingly, there has been a need for a superconducting analog-to-digital converter that does not require this additional logic circuitry.

### SUMMARY OF THE INVENTION

European patent application 90308873.0, from which the present application has been divided, describes a high speed, high-resolution superconducting counting A/D converter providing greatly increased conversion speeds with a low device count. The superconducting counting A/D converter includes a double-junction SQUID quantizer and a bidirectional binary counter having n stages of four-junction SQUID flip-flops that may be either floating or grounded, where n is the number of bits of accuracy of the counter. The quantizer continuously tracks an analog signal, generating up-count and down-count voltage pulses of the same polarity on two different output lines for increasing and decreasing values of the analog current, respectively. The bidirectional binary counter algebraically counts the voltage pulses, increasing the binary count when up-count pulses are received and decreasing the binary count when down-count pulses are received.

The quantizer includes two Josephson junctions and a center-tapped inductance connected together to form a superconducting loop. A constant gate current is injected into the center-tap terminal of the inductance, while the analog signal is transformer-coupled through a winding to the inductance. The bidirectional binary counter includes n stages of the floating four-junction SQUID flip-flops connected together in a cascade arrangement from the least significant bit (LSB) to the most significant bit (MSB). Each floating four-junction SQUID flip-flop includes four Josephson junctions and two center-tapped inductances connected together to form a superconducting loop.

The four-junction SQUID flip-flop is a bistable logic circuit in which the direction of the circulating current determines the state of the circuit. A "O" bit is represented by a counterclockwise circulating supercurrent and a "I" bit is represented by a clockwise circulating supercurrent When an up-count or down-count pulse is applied to the SQUID flip-flop, the current through one of the Josephson junctions is raised momentarily above the critical current of the junction. This causes the Josephson junction to generate a voltage pulse, thereby reversing the direction of the circulating current. Subsequent pulses applied to the SQUID flip-flop cause the flip-flop to toggle or reverse state. In this manner, an up-count pulse will ripple from flip-flop to flip-flop, changing the binary state of each stage and generating a carry pulse if the initial state of the stage is a "1." A down-count pulse will also ripple from flip-flop to flip-flop, changing the binary state of each stage and generating a borrow pulse if the initial state of the stage is a "0."

In an alternative embodiment of the high-speed high-resolution superconducting counting A/D converter, the quantizer is a single-junction SQUID quantizer. The single-junction quantizer generates up-count and down-count voltage pulses of the opposite polarity on a single output line for positive and negative values of an analog voltage, respectively. The quantizer digitizes an analog voltage, rather than an analog current, using the alternating current effect of Josephson junctions. When a voltage is applied to a Josephson junction, an alternating current is generated across the junction. Because the frequency of the current is dependent on the magnitude of the voltage, the average voltage during the sampling interval can be digitized by counting the frequency of the alternating current over that time interval.

In another alternative embodiment of the high speed high-resolution superconducting counting A/D converter, the SQUID flip-flops are grounded three-junction SQUID flip-flops. Each grounded three-junction SQUID flip-flop includes two inductances and three Josephson junctions. Two of the Josephson junctions are similar to the two Josephson junctions in the four-junction SQUID flip-flop and the third Josephson junction replaces the other two Josephson junctions by pulsing either positively or negatively. In still another alternative embodiment of the high-speed superconducting counting A/D converter, the quantizer and the LSB four-junction SQUID flip-flop are combined to provide a four-junction SQUID quantizer having an additional bit of sensitivity.

The present invention provides apparatus adapted to facilitate reading of the contents of the counter of a high-speed, high-resolution superconducting counting A/D converter at the end of each sampling interval. One technique for reading the contents of the counter is to utilize a toggling quantizer and two bidirectional binary counters. The quantizer toggles between the two counters at the end of each sampling interval so that one counter can be read while the other counter is counting, and vice versa. An adder combines the outputs of the two counters. Another technique for reading the contents of the binary counter is to utilize a variable-hysteresis quantizer. The variable-hysteresis quantizer inhibits the generation of voltage pulses during the read period, allowing the counter to be read without missing any changes in the analog signal.

More particularly, the present invention provides a superconducting quantum interference device (SQUID) quantizer comprising:
means for applying a variable analog signal to the quantizer;
one or more output terminals for outputting up-count and down-count voltage pulses dependent upon the level of the analog signal; and
means for selectively inhibiting the output of up-count and down-count voltage pulses on said one or more output terminals.

The present invention further provides a superconducting counting analog-to-digital converter comprising:
a superconducting quantum interference device (SQUID) quantizer;
means for applying a varying analog signal to the SQUID quantizer; and
a binary counter;
wherein the quantizer generates up-count and down-count voltage pulses for increasing and decreasing values of the analog signal and the binary counter algebraically counts the voltage pulses, increasing the binary count when up-count pulses are received and decreasing the binary count when down-count pulses are received;
characterised in that there is provided control means for selectively inhibiting the reception of voltage pulses by the binary counter whereby to provide a period of time during which the counter may be read.

Certain embodiments of A/D converter according to the present invention include bidirectional binary converters having n stages of four-junction SQUID flip-flops as in European patent application 90308873.0.

Such A/D convertors have many advantages, including very fast A/D conversion speeds and a low device count. These advantages result from the ability of the four-junction SQUID flip-flops to control both the binary states of the stages of the counter and the bidirectional transitions and propagations of the counter. The gates that would normally process this logic cannot operate at the required speeds. Therefore, eliminating the logic gates results in an extremely fast counter which can count up or down at speeds greater than 1 count every 10 picoseconds, or a counting rate of 100 GHz. Eliminating the logic gates also reduces the device count, which greatly enhances reliability and reduces power consumption and cost.

Features and advantages of the present invention will become apparent from the following more detailed description, taken in conjunction with the accompanying drawings, which illustrate, by way of example, the principles of the invention.

### BRIEF DESCRIPTION OF THE DRAWINGS

Figure 1 is a circuit diagram of a single-junction SQUID device;
Figure 2 is a graph of the magnetic flux as a function of injected current for the single-junction SQUID;
Figure 3A is a circuit diagram of a high-speed, high-resolution superconducting A/D converter with floating four-junction SQUID;
Figure 3B is a circuit diagram of a high-speed,high resolution superconducting A/D converter with grounded four-junction SQUID;
Figure 4 is a circuit diagram of a single-junction SQUID quantizer;
Figure 5 is a circuit diagram of a toggling quantizer and two bidirectional counters;
Figure 6 is a diagram of the current flowing through the toggling quantizer as a function of time;
Figure 7 is a circuit diagram of a variable-hysteresis quantizer;
Figure 8 is a diagram of the hysteresis of the variable-hysteresis quantizer as a function of time;
Figure 9 is a diagram of the voltage pulses generated by the variable-hysteresis quantizer as a function of time.
Figure 10 is a circuit diagram of a junction SQUID flip-flop; and
Figure 11 is a circuit diagram of a four-junction SQUID quantizer.

### DETAILED DESCRIPTION OF THE PREFERRED EMBODIMENTS

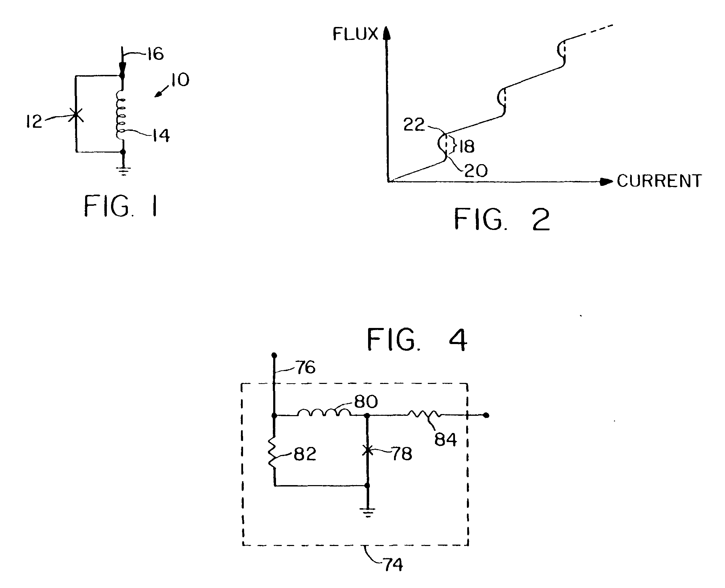

Figure 1 illustrates a single-junction SQUID 10 in which a Josephson junction 12 is connected across an inductance 14 to form a superconducting loop. One terminal of the inductance 14 is connected to a current source, indicated at 16, and the other terminal is connected to ground. Figure 2 is a simplified representation of the relationship between the injected current and the magnetic flux in the loop. As the current increases, the magnetic flux also increases, until a multi-valued region of the curve is reached, as indicated at 18. When a current-reversal point 20 is reached, a further increase in the current causes the magnetic flux to jump to a higher level of the multi-valued region, as indicated at 22. This sudden flux increment results in a small but measurable voltage pulse across the Josephson junction 12.

The curve of Figure 2 is perfectly periodic in that the current increments between successive peaks in the curve are uniform, as are the magnetic flux increments that are generated as a result of the current increments. When the current through the circuit falls, the magnetic flux in the loop is reduced, and corresponding voltage pulses of the opposite polarity are generated across the Josephson junction 12. These characteristics of the SQUID are the basis for A/D conversion using superconducting devices.

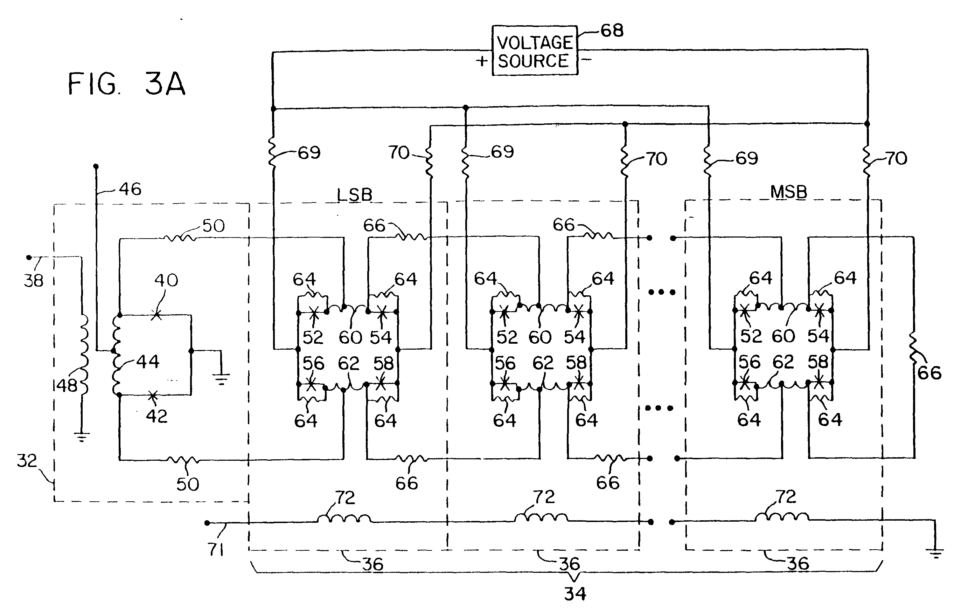

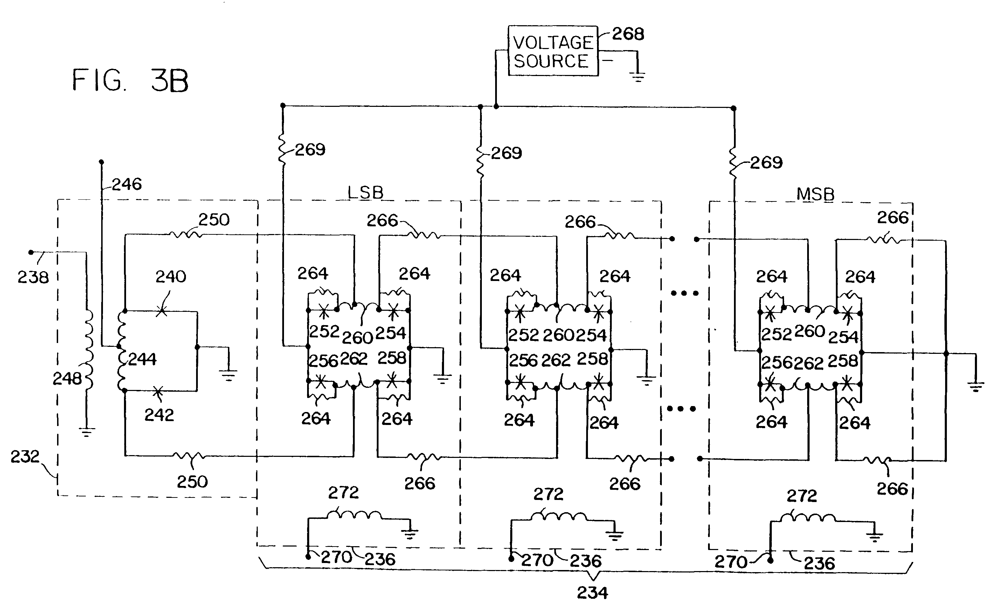

In the following description of Figures of 3A and 3B the same reference numerals identify like circuit elements. It will be appreciated that the circuits in Figures 3A and 3B are similar with the exception of the floating or grounded connection. Figures 3A and 3B illustrate a high-speed, high resolution superconducting counting A/D converter with Figure 3A representing the bidirectional counter 34 having n stages of floating four-junction SQUID flip-flops 36 and in Figure 3B the four-junction SQUID flip-flops 236 are grounded. Figure 3A illustrates a high-speed, high- resolution superconducting counting A/D converter. The superconducting counting A/D converter includes a double-junction SQUID quantizer 32 and a bidirectional binary counter 34 having n stages of floating four-junction SQUID flip-flops 36, where n is the number of bits of accuracy of the counter. In Figure 3B the A/D converter includes a double junction SQUID quantizer 232 and a bidirectional binary counter 234 having n states of grounded four-junction SQUID flip-flops 236.. The quantizer 232 continuously tracks an analog signal, on line 238, generating up-count and down-count voltage pulses of the same polarity on two different output lines for increasing and decreasing values of the analog current, respectively. The bidirectional binary counter 34 (Fig 3A) and 234 (Fig. 3B) algebraically counts the voltage pulses, increasing the binary count when up-count pulses are received and decreasing the binary count when down-count pulses are received.

Referring to Fig. 3A,the quantizer 32 includes two Josephson junctions 40, 42 and a center-tapped inductance 44 connected together to form a superconducting loop. One terminal of each of the Josephson junctions 40, 42 is connected to a different end terminal of the inductance 44 and the other terminal of each of the Josephson junctions 40, 42 is connected to ground. A constant gate current, on line 46, is injected into the center-tap terminal of the inductance 44. The analog signal on line 38 is transformer-coupled through a winding 48 to the inductance 44. Alternatively, the analog signal on line 38 may be directly coupled into the inductance 44. Positive incremental changes in the analog current result in the generation of up-count voltage pulses across Josephson junction 40 and negative incremental changes in the analog current result in the generation of down-count voltage pulses across Josephson junction 42. These up-count and down-count signals are output to the binary counter 34 from the terminals between the inductance 44 and the Josephson junctions 40, 42, respectively, and are each applied to the counter through a resistor 50.

The bidirectional binary counter 34 includes n stages of the floating four-junction SQUID flip-flops 36 connected together in a cascade arrangement from the least significant bit (LSB) to the most significant bit (MSB). Each floating four-junction SQUID flip-flop 36 includes four Josephson junctions 52, 54, 56, 58 and two center-tapped inductances 60, 62 connected together to form a superconducting loop. One terminal of each of the Josephson junctions 52, 54 is connected to a different end terminal of inductance 60 and one terminal of each of the Josephson junctions 56, 58 is connected to a different end terminal of inductance 62. The other terminals of Josephson junctions 52, 56 are connected together and the other terminals 5 of Josephson junctions 54, 58 are connected together. Each of the Josephson junctions 52, 54, 56, 58 also has a shunt resistor 64 connected across its terminals.

The center-tap terminal of inductance 60 receives the carry signal from the preceding four-junction SQUID flip-flop 36 and 36', or the up-count signal from the quantizer 32 if the four-junction SQUID flip-flop is the LSB flip-flop, and the center-tap terminal of inductance 62 receives the down-count or borrow signal. The carry and borrow signals are output to the succeeding four-junction SQUID flip-flop 36 from the terminal between Josephson junction 54 and inductance 60 and from the terminal between Josephson junction 58 and inductance 62, respectively, and are each applied to the succeeding SQUID flip-flop through a resistor 66.

A constant gate current is supplied to each four-junction SQUID flip-flop 36 by applying an ungrounded constant voltage source 68 ungrounded to resistors 69 (Figure 3A). The constant gate current flows through each SQUID flip-flop from the terminal between Josephson junctions 52, 56 to the terminal between Josephson junctions 54, 58, where it is returned to the constant voltage source 68 through resistors 70. Because the voltage source 68 and the four-junction SQUID flip-flops 36 are ungrounded, the SQUID flip-flops operate in a floating mode. This allows all four Josephson junctions to be identical, providing a symmetrical SQUID flip-flop. A flux bias of F_{O}/2, where F_{O} is a flux quantum h/2e = 2.07 x 10⁻¹⁵ weber, is generated in each SQUID flip-flop by a flux bias line 71 and inductances 72. Alternatively, the flux bias can be applied to the SQUID flip-flops by individual flux bias lines rather than by the single flux bias line 71. The flux bias induces a flux bias current in each SQUID flip-flop. The Josephson junctions 52, 54, 56, 58 are resistively 5 shunted so that the SQUID flip-flops 36 operate in a nonlatching mode, which allows the SQUID flip-flops to operate at much faster speeds than when operated in a latching mode.

Each four-junction SQUID flip-flop 36 (Fig. 3A) is a bistable logic circuit in which the direction of the circulating current determines the state of the circuit. A "O" bit is represented by a counterclockwise circulating supercurrent and a "I" bit is represented by a clockwise circulating supercurrent. When an up-count/carry pulse or a down-count/borrow pulse is applied to the SQUID flip-flop, the current through one of the Josephson junctions is raised momentarily above the critical current of the junction. This causes the Josephson junction to generate a voltage pulse, thereby reversing the direction of the circulating current. Subsequent pulses applied to the SQUID flip-flop cause the flip-flop to toggle or reverse state. In this manner, an up-count or carry signal will ripple from flip-flop to flip-flop, changing the binary state of each stage and generating a further carry signal if the initial state of the stage is a "1." A down-count or borrow signal will also ripple from flip-flop to flip-flop, changing the binary state of each stage and generating a further borrow signal if the initial state of the stage is a "0."

Referring further to Figure 3A there are four possible transitions for each of the SQUID flip-flops, 36, from a "0" up to a "1," from a "O" down to a "1," from a "1" up to a "0," and from a "I" down to a "0." When a SQUID flip-flop is indicating a "0," an up-count or carry signal causes Josephson junction 56, while a down-count or borrow signal causes Josephson junction 58, to pulse and output a borrow signal to the succeeding SQUID flip-flop. When a SQUID flip-flop is indicating a "I", an 5 up-count or carry signal causes Josephson junction 54, to pulse and output a carry signal to the succeeding SQUID flip-flop, while a down-count or borrow signal causes Josephson junction 52 to pulse. Accordingly, Josephson junction 54 are the add-with-carry junction, Josephson junction 56 are the add-without-carry junction, Josephson junction 58 are the subtract-with-borrow junction, and Josephson junction 52 are the subtract-without-borrow junction.

Looking at each of the transitions in Fig. 3A in more detail, when a bit is indicating a "0," the flux bias current and the gate current combine positively in Josephson junctions 56, 58 and , and negatively in Josephson junctions 52,54.Accordingly, Josephson junctions 56 and 58,support relatively large current flows which will allow them to pulse due to a carry or borrow signal. An up-count or carry signal supplies current to the loop which combines positively with the current through Josephson junction 56 and negatively with the current through Josephson junction 58. Therefore, the current through Josephson junction 56 will exceed its critical current, causing the junction to generate a voltage pulse. The circulation state of the SQUID flip-flop will change to a clockwise direction, indicating a "1," and no carry or borrow signal will be propagated to the next bit.

A down-count or borrow signal supplies current to the loop which combines positively with the current through Josephson junction 58 and negatively with the current through Josephson junction 56. Therefore, the current through Josephson junction 58 will exceed its critical current, causing the junction to generate a voltage pulse. The circulation state of the SQUID flip-flop will change to a clockwise direction, and a borrow signal will be propagated to the next bit.

When a bit is indicating a "1," the flux bias current and the gate current combine positively in Josephson junctions 52, 54 and negatively in Josephson junctions 56, 58. Accordingly, Josephson junctions 52, and 54 support relatively large current flows which will allow them to pulse due to a carry or borrow signal. An up-count or carry signal supplies current to the loop which combines positively with the current through Josephson junction 54 and negatively with the current through Josephson junction 52. Therefore, the current through Josephson junction 54 will exceed its critical current, causing the junction to generate a voltage pulse. The circulation state of the SQUID flip-flop will change to a counterclockwise direction, indicating a "0," and a carry signal will be propagated to the next bit.

A down-count or borrow signal supplies current to the loop which combines positively with the current through Josephson junction 52 and negatively with the current through Josephson junction 54. Therefore, the current through Josephson junction 52 will exceed its critical current, causing the junction to generate a voltage pulse. The circulation state of the SQUID flip-flop will change to a counterclockwise direction, and no carry or borrow signal will be propagated to the next bit.

In the following description of Figure 3B it will be appreciated that with the exception of the Josephson junctions 236 being electrically grounded the operation is similar to the circuit in Figure 3A. Referring further to Figure 3B, a constant gate current is supplied to each four-junction SQUID flip-flop 236 by applying a grounded constant voltage source 268 to resistors 269. The constant gate current flows through each SQUID flip-flop from the terminal between Josephson junctions 252, 256 to the terminal between Josephson functions 254, 258, where it is grounded. Because the voltage source 268 and the four-junction SQUID flip-flops 236 are grounded, the critical current of Josephson junctions 252, 256 should be about 30% less than that of Josephson junctions 254, 258.

A flux bias of F_{O}/2, where F_{O} is a flux quantum h/2e = 2.07 x 10⁻¹⁵ weber, is generated in each SQUID flip-flop by individual flux bias lines 270 and inductances 272. Alternatively, the flux bias can be applied to the SQUID flip-flops by a single flux bias line rather than by individual flux bias lines. The flux bias induces a flux bias current in each SQUID flip-flop. The Josephson junctions 252, 254, 256, 258 are resistively shunted so that the SQUID flip-flops 236 operate in a nonlatching mode, which allows the SQUID flip-flops to operate at much faster speeds than when operated in a latching mode.

Each four-junction SQUID flip-flop 236 is a bistable logic circuit which operates in the same manner as described in connection with Figure 3A. The four possible transitions for each of the SQUID flip-flops 236, from a "0" up to a "1", from a "0" down to a "1", from a "1" up to a "0", and from a "1" down to a "0" function the same as the flip-flops 36 in Figure 3A.

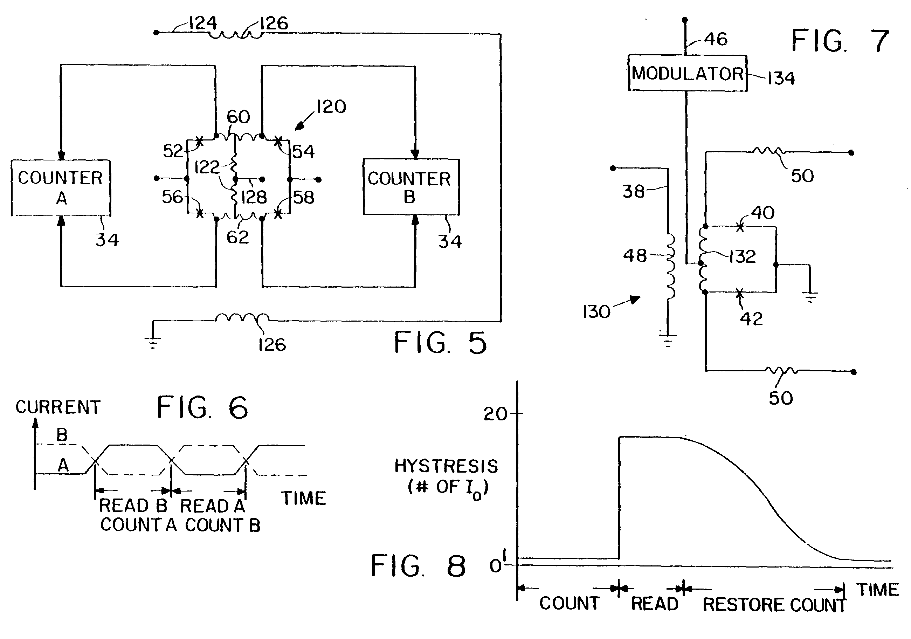

In an alternative embodiment of the high-speed, high-resolution superconducting counting A/D converter the quantizer is a single-junction SQUID quantizer 74, as illustrated in 35 Figure 4. The single-junction quantizer 74 generates up-count and down-count voltage pulses of the opposite polarity on a single output line for positive and negative values of an analog voltage, on line 76. In the LSB SQUID flip-flop 36 of the bidirectional binary 5 counter 34, the single output line of the quantizer 74 is applied to the center-tap terminal of inductance 60, while the center-tap terminal of inductance 62 is grounded.

The single-junction quantizer 74 includes a Josephson junction 78, an inductance 80 and a resistor 82 connected together to form a superconducting loop. One terminal of the inductance 80 is connected to a terminal of the Josephson junction 78, the other terminal of the inductance 80 is connected to a terminal of the resistor 82 and the other terminal of the resistor 82 is connected to the other terminal of the Josephson junction 78. The terminal between the Josephson junction 78 and the resistor 82 is grounded and the terminal between the inductance 80 and the resistor 82 receives the analog signal. The up-count/down-count signal is output to the binary counter from the terminal between the inductance 80 and the Josephson junction 78 and is applied to the counter through a resistor 84.

The single-junction SQUID quantizer 74 digitizes an analog voltage, rather than an analog current, using the alternating current effect of Josephson junctions. When a voltage is applied to a Josephson junction, an alternating current is generated across the junction. Because the frequency of the current is dependent on the magnitude of the voltage, the average voltage during the sampling interval can be digitized by counting the frequency of the alternating current over that time interval.

The present invention provides means for reading the contents of the counter of the above-described high-speed, high-resolution superconducting counting A/D converters at each end of each sampling interval. One technique for reading the contents of the counter is to utilize a toggling quantizer 120 and two bidirectional binary counters 34, as illustrated in Figure 5. The quantizer 120 toggles between the two counters at the end of each sampling interval so that counter A can be read while counter B is counting, and vice versa. An adder (not shown) combines the outputs of the two counters.

The toggling quantizer 120 includes the four Josephson junctions 52, 54, 56, 58 and the two inductances 60, 62 of the four-junction SQUID flip-flop 36, and first and second resistors 122. One terminal of the first resistor 122 is connected to the center-tap terminal of inductance 60, one terminal of the second resistor 122 is connected to the center-tap terminal of inductance 62 and the other terminals of the resistors 122 are connected together. An analog signal, on line 124, is transformer-coupled through windings 126 to the inductances 60, 62. A constant gate current, on line 128, is injected into the quantizer at the terminal between the two resistors 122.

Counter A is selected for counting by grounding the terminal between Josephson junctions 52, 56 and counter B is selected for counting by grounding the terminal between Josephson junctions 54, 58. The gate current flows through the two Josephson junctions having the grounded terminal, which allows the two Josephson junctions to be switched by the analog current. A diagram of the gate current flowing through the quantizer as a function of time is illustrated in Figure 6. No information can be lost during the toggling because at the crossover points, when the currents A and B are equal, one counter or the other will receive the pulses.

When counter A is selected, positive incremental changes in the analog current result in the generation of up-count voltage pulses across Josephson junction 52 and negative incremental changes result in the generation of down-count voltage pulses across Josephson junction 56. When counter B is selected, positive incremental changes in the analog current result in the generation of up-count voltage pulses across Josephson junction 54 and negative incremental changes result in the generation of down-count voltage pulses across Josephson junction 58. The up-count signal is output to counter A from the terminal between inductance 60 and Josephson junction 52 and to counter B from the terminal between inductance 60 and Josephson junction 54. The down-count signal is output to counter A from the terminal between inductance 62 and Josephson junction 56 and to counter B from the terminal between inductance 62 and Josephson junction 58.

Another technique for reading the contents of the binary counter 34 is to utilize a variable-hysteresis quantizer 130, as illustrated in Figure 7. The variable-hysteresis quantizer 130 inhibits the generation of voltage pulses during the read period, allowing the counter to be read without missing any changes in the analog signal. The variable-hysteresis quantizer 130 includes the two Josephson junctions 40, 42 of the double-junction SQUID quantizer 32 and a center-tapped inductance 132. One terminal of each of the Josephson junctions 40, 42 is connected to a different end terminal of the inductance 132 and the other terminal of each of the Josephson junctions 40, 42 is connected to ground. The constant gate current on line 46 is modulated by modulator 134, with the modulated gate current being injected into the center-tap terminal of the inductance 132. The analog signal on line 38 is transformer-coupled through winding 48 to the inductance 132.

The inductance 132 is large so that the quantizer 130 has a β_{L} >> π, where β_{L} is defined as 2πLI_{C}/F₀ and L is the inductance of the quantizer 130, I_{C} is the critical current of the Josephson junctions 40, 42 and F₀ is the flux quantum. The hysteresis of the quantizer 130 is controlled by the modulated gate current, with a small gate current producing a large hysteresis and a large gate current producing a small hysteresis.

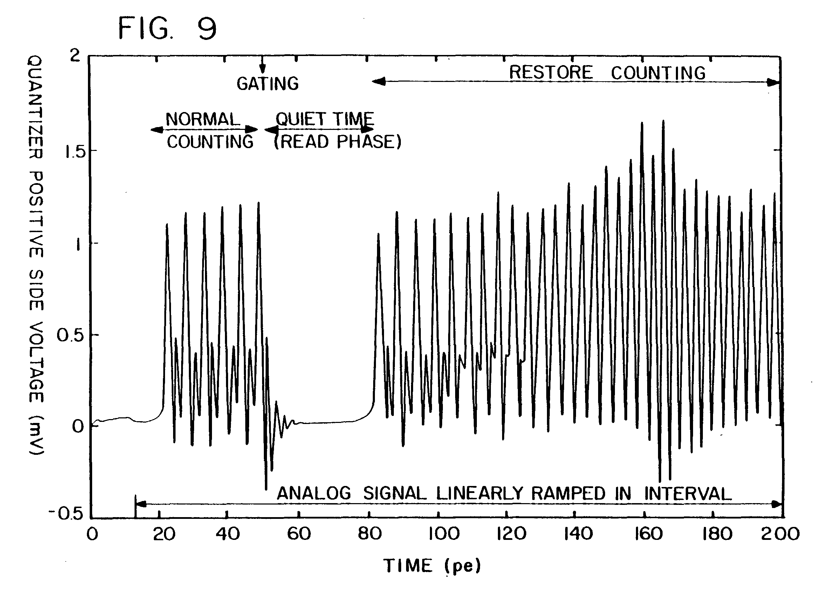

As shown in Figures 8 and 9, during the sampling interval, a small hysteresis allows the quantizer to output up-count and down-count signals to the bidirectional binary counter 34. At the end of the sampling interval, the hysteresis is rapidly increased to inhibit the generation of any additional voltage pulses. During this read period, the bits of the counter are read sequentially starting with the LSB. Any changes in the analog signal during the read period are stored in the quantizer loop as magnetic flux. The hysteresis of the quantizer is then decreased, which allows the generation of voltage pulses to be resumed. By slowly decreasing the hysteresis, the output pulse train from the quantizer is slightly compressed, as shown in Figure 9. This allows the quantizer to output new pulses and also recover the pulses that were stored in the quantizer during the read period.

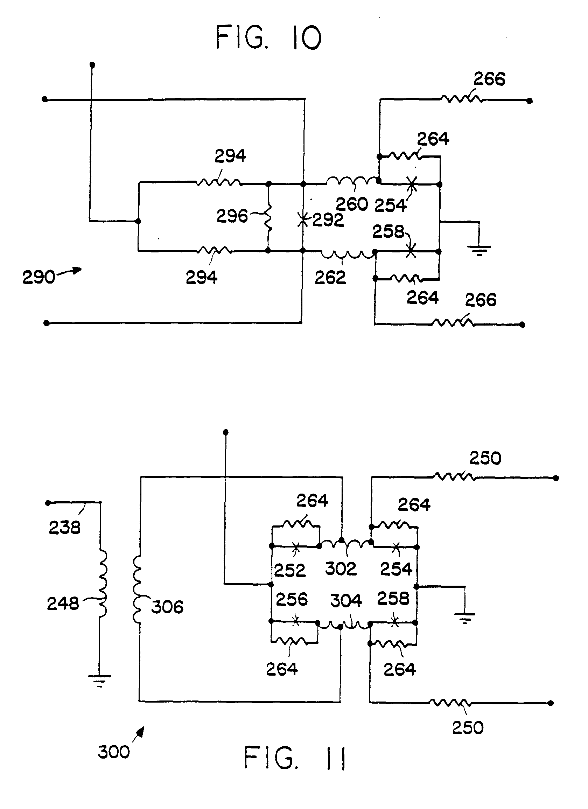

In another alternative embodiment of the high-speed superconducting counting A/D converter the SQUID flip-flops are grounded three-junction SQUID flip-flops 290, as illustrated in Figure 10. Each grounded three-junction SQUID flip-flop 290 includes the two inductances 260, 262 and the two Josephson junctions 254, 258 of the grounded four-junction SQUID flip-flop 236. The three-junction SQUID flip-flop 290 also includes a third Josephson junction 292, first and second resistors 294 and a shunt resistor 296. A terminal of the first resistor 294 is connected to the other terminal of inductance 260, a terminal of the second resistor 294 is connected to the other terminal of inductance 262 and the other terminals of the first and second resistors 294 are connected together. One terminal of the shunt resistor 296 and one terminal of Josephson junction 292 are connected to the terminal between the first resistor 294 and inductance 260 and the other terminal of the shunt resistor 296 and the other terminal of Josephson junction 292 are connected to the terminal between the second resistor 294 and inductance 262. The constant gate current is injected into the three-junction SQUID flip-flop 290 at the terminal between the first and second resistors 294.

The terminal between the first resistor 294 and inductance 260 receives the carry signal from the preceding three-junction SQUID flip-flop 290, or the up-count signal from the quantizer 232 if the three-junction SQUID flip-flop is the LSB flip-flop, and the terminal between the second resistor 294 and inductance 262 receives the down-count or borrow signal. The carry and borrow signals are output to the succeeding three-junction SQUID flip-flop 290 as in the four-junction SQUID flip-flop 236.

In the three-junction SQUID flip-flop 290, Josephson junctions 254, 258 operate as they do in the four-junction SQUID flip-flop 236 and Josephson junction 292 replaces Josephson junctions 252, 256. Josephson junction 292 performs the operations of the two Josephson junctions by pulsing either positively or negatively. Josephson junction 292 does not carry any gate current, only circulating current, and therefore the critical current of Josephson junction 292 should be about 60% less than that of the other two Josephson junctions 254, 258.

In still another alternative embodiment of the high-speed superconducting counting A/D converter, the quantizer and the LSB four-junction SQUID flip-flop are combined to provide a four-junction SQUID quantizer 300 having an additional bit of sensitivity. As illustrated in Figure 11, the four-junction SQUID quantizer 300 includes the four Josephson junctions 252, 254, 256, 258 and the shunt resistors 264 of the grounded four-junction SQUID flip-flop 236. The four-junction SQUID quantizer 300 also includes two center-tapped inductances 302, 304 and an inductance 306. One terminal of each of the Josephson junctions 252, 254 is connected to a different end terminal of inductance 302 and one terminal of each of the Josephson junctions 256, 258 is connected to a different end terminal of inductance 304. The other terminals of Josephson junctions 252, 256 are connected together and the other terminals of Josephson junctions 254, 258 are connected together.

The A/D converters described above have many advantages, including very fast A/d conversion speeds and a low device count. These advantages result from the ability of the four-junction SQUID flip-flops to control both the binary states of the stages of the counter and the bidirectional transitions and propagations of the counter. The gates that would normally process this logic cannot operate at the required speeds. Therefore, eliminating the logic gates results in an extremely faster counter which can count up or down at speeds greater than 1 count every 10 picoseconds, or a counting rate of 100 GHz. Eliminating the logic gates also reduces the device count, which greatly enhances reliability and reduces power consumption and cost.

## Claims

1. A superconducting counting analog-to-digital converter comprising:
a superconducting quantum interference device (SQUID) quantizer (32);
means (38,48) for applying a varying analog signal to the SQUID quantizer; and
a binary counter (34);
wherein the quantizer (32) generates up-count and down-count voltage pulses, for increasing and decreasing values of the analog signal, and the binary counter algebraically counts the voltage pulses, increasing the binary count when up-count pulses are received and decreasing the binary count when down-count pulses are received;
characterised in that there is provided control means (134 or 120) for selectively inhibiting the reception of voltage pulses by the binary counter, to provide a period of time during which the counter may be read.

2. The superconducting counting analog-to-digital converter of claim 1 wherein the superconducting quantum interference device (SQUID) quantizer (130) has variable hysteresis and the control means (134) is adapted to control the hysteresis of the quantizer, a small hysteresis allowing the quantizer to output the up-count and down-count pulses to the binary counter (34) and a large hysteresis inhibiting the generation of the voltage pulses.

3. The superconducting counting analog-to-digital converter of claim 2 wherein the variable hysteresis quantizer (130) includes:
first and second Josephson junctions (40,42); and
a center-tapped inductance (132);
and wherein the control means (134) comprises means for supplying a variable gate current to quantizer (130), the hysteresis of the quantizer being controlled by the gate current.

4. The superconducting counting analog-to-digital converter of claim 1 wherein:
there is further provided a second binary counter (34B); and
the quantizer and control means are constituted by a toggling superconducting quantum interference device (SQUID) quantizer (120) which, in use, toggles between the two counters (34A, 34B) at the end of each sampling interval so that one counter can be read while the other counter is counting.

5. The superconducting counting analog-to-digital converter of claim 4 wherein the toggling quantizer (120) includes:
first, second, third and fourth Josephson junctions (52, 54, 56, 58);
first and second center-tapped inductances (60, 62);
two resistors (122) connected in series between the center-tap terminals of the two inductances (60, 62); and
means (128) for injecting a constant gate current into the terminal between the two resistors (122);
wherein the first counter (34A) is selected for counting by grounding the terminal between the first and third Josephson junctions (52, 56) and the second counter (34B) is selected for counting by grounding the terminal between the second and fourth Josephson junctions (54, 58);
and wherein when the first counter (34A) is selected for counting, positive incremental changes in the analog signal result in the generation of up-count voltage pulses across the first Josephson junction (52) and negative incremental changes in the analog signal result in the generation of down-count voltage pulses across the third Josephsori junction (56), and when the second counter (34B) is selected for counting, positive incremental changes in the analog signal result in the generation of up-count voltage pulses across the second Josephson junction (54) and negative incremental changes in the analog signal result in the generation of down-count voltage pulses across the fourth Josephson junction (58).

## Patentansprüche

1. Ein supraleitender zählender Analog-Digital-Konverter mit:
einem supraleitenden Quanteninterferenzvorrichtungs-(SQUID)-Quantisierer (32),
Einrichtungen (38, 48), um dem SQUID-Quantisierer ein sich änderndes analoges Signal zuzuführen, und
einen Binärzähler (34),
wobei der Quantisierer (32) Aufwärtszähl- und Abwärtszähl-Spannungspulse für ansteigende und abfallende Werte des analogen Signals erzeugt und der Binärzähler die Spannungspulse algebraisch zählt, wobei die Binärzählung erhöht wird; wenn Aufwärtszählpulse empfangen werden, und die Binärzählung verringert wird, wenn Abwärtszählpulse empfangen werden,
dadurch gekennzeichnet, daß Steuereinrichtungen (134 oder 120) bereitgestellt sind, um den Empfang von Spannungspulsen durch den Binärzähler selektiv zu verhindern, um eine Zeitperiode bereitzustellen, während der der Zähler ausgelesen werden kann.

2. Der supraleitende zählende Analog-Digital-Konverter gemäß Anspruch 1, bei dem der supraleitende Quanteninterferenzvorrichtungs-(SQUID)-Quantisierer (130) eine variable Hysterese aufweist und die Steuereinrichtung (134) ausgelegt ist, die Hysterese des Quantisierers zu steuern, wobei es eine kleine Hysterese ermöglicht, daß der Quantisierer die Aufwärtszähl- und Abwärtszählpulse an den Binärzähler (34) ausgibt, während eine große Hysterese die Erzeugung der Spannungspulse verhindert.

3. Der supraleitende zählende Analog-Digital-Konverter gemäß Anspruch 2, bei dem der Quantisierer (130) mit variabler Hysterese aufweist:
erste und zweite Josephson-Übergänge (40, 42), und
eine Induktanz (132) mit Mittenabgriff,
und bei dem die Steuereinrichtung (134) Einrichtungen umfaßt, um dem Quantisierer (130) einen variablen Gatestrom zuzuführen, wobei die Hysterese des Quantisierers durch den Gatestrom gesteuert wird.

4. Der supraleitende zählende Analog-Digital-Konverter gemäß Anspruch 1, bei dem:
ferner ein zweiter Binärzähler (34B) bereitgestellt ist, und
der Quantisierer und die Steuereinrichtung durch einen hin- und herschaltenden supraleitenden Quanteninterferenzvorrichtungs-(SQUID)-Quantisierer (120) gebildet werden, der bei Verwendung zwischen den zwei Zählern (34A, 34B) am Ende jedes Abtastintervalls so hin- und herschaltet, daß ein Zähler ausgelesen werden kann, während der andere Zähler zählt.

5. Der supraleitende zählende Analog-Digital-Konverter gemäß Anspruch 4, bei dem der hin- und herschaltende Quantisierer (120) umfaßt:
erste, zweite, dritte und vierte Josephson-Übergänge (52, 54, 56, 58),
erste und zweite Induktanzen (60, 62) mit Mittenabgriff,
zwei Widerstände (122), die zwischen den Mittenabgriffsanschlüssen der zwei Induktanzen (60, 62) in Reihe angeschlossen sind, und
Einrichtungen (128), um einen konstanten Gatestrom in den Anschluß zwischen den zwei Widerständen (122) einzuspeisen,
bei dem der erste Zähler (34A) zum Zählen ausgewählt wird, indem der Anschluß zwischen den ersten und dritten Josephson-Übergängen (52, 56) geerdet wird, und der zweite Zähler (34B) zum Zählen ausgewählt wird, indem der Anschluß zwischen den zweiten und vierten Josephson-Übergängen (54, 58) geerdet wird,
und bei dem positive inkrementelle Änderungen in dem analogen Signal zu der Erzeugung von Aufwärtszähl-Spannungspulsen über dem ersten Josephson-Übergang (52) und negative inkrementelle Änderungen in dem analogen Signal zu der Erzeugung von Abwärtszähl-Spannungspulsen über dem dritten Josephson-Übergang (56) führen, wenn der erste Zähler (34A) zum Zählen ausgewählt ist, und positive inkrementelle Änderungen in dem analogen Signal zu der Erzeugung von Aufwärtszähl-Spannungspulsen über dem zweiten Josephson-Übergang (54) und negative inkrementelle Änderungen in dem analogen Signal zu der Erzeugung von Abwärtszähl-Spannungspulsen über dem vierten Josephson-Übergang (58) führen, wenn der zweite Zähler (34B) zum Zählen ausgewählt ist.

## Revendications

1. Convertisseur analogique-numérique de comptage supraconducteur comprenant :
un quantifieur de dispositif d'interférence de quantum supraconducteur (SQUID) (32) ;
un moyen (38,48) pour appliquer un signal analogique variable au quantifieur SQUID ; et
un compteur binaire (34) ;
dans lequel le quantifieur (32) génère des impulsions de tension de comptage progressif et de comptage régressif, pour augmenter et diminuer des valeurs du signal analogique, et le compteur binaire compte algébriquement les impulsions de tension, en augmentant le comptage binaire lorsque des impulsions de comptage progressif sont reçues et en diminuant le comptage binaire lorsque des impulsions de comptage régressif sont reçues ;
caractérisé en ce qu'un moyen commande (134 ou 120) est fourni pour empêcher sélectivement la réception des impulsions de tension par le compteur binaire, pour fournir une période de temps pendant laquelle le compteur peut être lu.

2. Convertisseur analogique-numérique de comptage supraconducteur selon la revendication 1 dans lequel un quantifieur de dispositif d'interférence de quantum supraconducteur (SQUID) (130) ayant un hystérésis variable et un moyen de commande (134) est adapté pour commander l'hystérésis du quantifieur, un petit hystérésis permettant au quantifieur de fournir les impulsions de comptage progressif et de comptage régressif au compteur binaire (34) et un grand hystérésis empêchant la génération d'impulsions de tension.

3. Convertisseur analogique-numérique de comptage supraconducteur selon la revendication 2, dans lequel le quantifieur à hystérésis variable (130) comprend :
des première et seconde jonctions Josephson (40, 42) ; et
une inductance à prise centrale (132) ;
et dans lequel le moyen de commande (134) comprend un moyen pour fournir un courant de porte variable au quantifieur (130), l'hystérésis du quantifieur étant commandé par le courant de porte.

4. Convertisseur analogique-numérique de comptage supraconducteur selon la revendication 1, dans lequel :
un second capteur binaire (34B) est en outre fourni ; et
le quantifieur et le moyen de commande sont constitués par un quantifieur de dispositif d'interférence quantifieur supraconducteur (SQUID) (120) basculant qui, lors de l'utilisation, bascule entre les deux compteurs (34A, 34B) à la fin de chaque intervalle d'échantillonnage pour qu'un compteur puisse être lu alors que l'autre compteur compte.

5. Convertisseur analogique-numérique supraconducteur selon la revendication 4, dans lequel le quantifieur basculant (120) comprend :
des première, seconde, troisième et quatrième jonctions Josephson (52, 54, 56, 58) ;
des première et seconde inductions à prise centrale (60, 62) ;
deux résistances (122) montées en séries entre les bornes de prise centrale des deux inductances (60, 62) ; et
un moyen (128) pour injecter un courant de porte constant dans la borne entre les deux résistances (122) ;
dans lequel le premier compteur (34A) est sélectionné pour compter en mettant à la masse la borne entre les première et troisième jonctions Josephson (52, 56) et le second compteur (34B) est sélectionné pour compter en mettant à la masse la borne entre les seconde et quatrième jonctions Josephson (54, 48) ;
et dans lequel lorsque le premier compteur (34) est sélectionné pour compter, des variations incrémentales positives du signal analogique résultent en génération d'impulsions de tension de comptage régressif à travers la première jonction Josephson (52) et des variations incrémentales négatives du signal analogique résultent en génération d'impulsions de tension de comptage régressif à travers la troisième jonction Josephson (56), et lorsque le second compteur (34B) est sélectionné pour le comptage, des variations incrémentales positives du signal analogique résultent en génération d'impulsions de tension de comptage progressif à travers la seconde jonction Josephson (54), et des variations incrémentales négatives du signal analogique résultent en génération d'impulsions de tension de comptage régressif à travers la seconde jonction Josephson (58).
